# FASCICULE DE BREVET EUROPEEN

(11) **EP 2 193 602 B1**
(45) Date de publication et mention de la délivrance du brevet: **19.12.2018**
(21) Numéro de dépôt: 08804978.8
(22) Date de dépôt: 01.10.2008
(51) Int. Cl.: H03F 1/52

(54) **CIRCUIT DE PROTECTION POUR MOSFET**
SCHUTZSCHALTUNG FÜR MOSFET
PROTECTION CIRCUIT FOR MOSFET

(30) Priorité: 02.10.2007 FR 0706898
(43) Date de publication de la demande: 09.06.2010
(73) Titulaire: THALES, 92400 Courbevoie (FR)
(72) Inventeur: BOUCHET, André, F-49300 Cholet (FR); GERFAULT, Bertrand, F-49450 St Macaire En Mauges (FR)
(74) Mandataire: Lucas, Laurent Jacques
(86) Numéro de dépôt international: PCT/EP2008/063189
(87) Numéro de publication internationale: WO 2009/043892

(56) Documents cités:
- US-A- 3 792 292
- US-A- 4 678 950
- US-A- 5 229 660
- US-B1- 6 856 200
- US-B2- 6 594 131

## Description

La présente invention concerne un circuit de protection pour transistors à effet de champ en technologie MOS, ces transistors étant couramment appelés MOSFET en référence à l'expression anglo-saxonne « Metal-Oxide-Semiconductor Field Effect Transistor ». L'invention s'applique notamment à la protection des MOSFET de puissance compris dans des étages d'amplification de systèmes électroniques.

Les MOSFET de puissance utilisés dans les étages d'amplification de ces systèmes sont parfois soumis à des chocs électriques qui peuvent conduire à leur endommagement, voire à leur destruction. A titre d'exemple, un amplificateur de puissance présent dans un système de radiocommunications est parfois soumis à des changements brutaux d'impédances de charge, par exemple lors d'une connexion/déconnexion d'une antenne en sortie de l'amplificateur ou d'une commutation de bande spectrale en fonctionnement. En phase d'utilisation du système, l'accumulation de ces chocs électriques peut dégrader la fiabilité de l'amplificateur.

Par ailleurs, durant la phase de mise au point des systèmes électroniques, l'amplitude du courant électrique utilisé peut varier fortement du fait des essais opérés sur le système, rendant ainsi les composants, notamment les MOSFET, vulnérables aux destructions. Ces destructions pendant les phases de mise au point engendrent des surcoûts importants, certains MOSFET de puissance étant particulièrement coûteux.

Beaucoup de systèmes existants reposent sur l'utilisation de MOSFET dont les caractéristiques intrinsèques permettent de résister à des conditions de fonctionnement assez défavorables, sans pouvoir néanmoins protéger le MOSFET contre certains incidents tels que des courants d'excitation trop élevés. Quelques circuits ont été proposés afin de protéger les MOSFET. Notamment, il est connu d'associer au MOSFET un circuit se comportant comme un fusible coupant le courant d'excitation du MOSFET en cas de dysfonctionnement. Cependant, les circuits connus ne fonctionnent pas en radiofréquences et/ou requièrent beaucoup de composants.

Le brevet américain publié sous la référence US6856200 pour la société Marvell International Ltd. propose un circuit de protection comprenant un transistor de commutation jouant le rôle d'interrupteur entre la grille du MOSFET à protéger et la masse électrique, le transistor de commutation étant placé en position fermée lorsqu'un signal de commande est émis sur le drain dudit transistor de commutation. Toutefois, lorsque ce transistor de commutation est placé position ouverte, il joue le rôle non souhaité de capacité entre la grille du MOSFET et la masse électrique, cette capacité perturbant le fonctionnement du circuit comprenant le MOSFET, notamment aux fréquences élevées.

Le brevet US 6594131 décrit un système de protection en courant d'un IGBT pour des applications d'électronique de puissance. Le transistor de commutation utilisé est semblable à un transistor de commutation conventionnel NPN pour de faibles fréquences. Les composants ne sont pas adaptés à la protection du MOSFET opérant à des fréquences élevées de commutation.

Le circuit de protection ne doit, de préférence, ni affecter les performances du circuit comprenant le MOSFET ni restreindre ses plages de fonctionnement, en particulier en température.

Un but de l'invention est de protéger un MOSFET de l'endommagement ou de la destruction en lui associant un module protecteur comportant peu de composants et n'affectant pas ou quasiment pas le fonctionnement du circuit comprenant ledit MOSFET. A cet effet, l'invention a pour objet un circuit comportant au moins un MOSFET protégé par un module de blocage dudit MOSFET, le module étant placé entre la grille du MOSFET et un conducteur électrique, le module comportant des moyens de connexion commutés ayant au moins deux états :
▪ un premier état opérant une connexion de la grille du MOSFET avec le conducteur, lequel est maintenu à un potentiel électrique adapté à bloquer le MOSFET, ce premier état étant activé en présence d'un signal d'alarme,
▪ un deuxième état opérant une déconnexion de la grille du MOSFET, ce deuxième état étant activé en l'absence de signal d'alarme,
les moyens de commutation comportent au moins une diode PIN et un transistor de commutation à effet de champ, l'anode de la diode étant reliée à la grille du MOSFET, la cathode de la diode étant reliée au drain du transistor de commutation, la source du transistor de commutation étant reliée au conducteur électrique, et la grille du transistor de commutation étant commandée par le signal d'alarme, le MOSFET opérant dans le domaine des radiofréquences,
où le signal d'alarme est généré par un module de commande comportant une pluralité de comparateurs, dont au moins un comparateur compare un signal de référence avec un second signal représentant une grandeur physique à surveiller pour générer un signal d'alerte lorsque le second signal dépasse un seuil défini par le signal de référence, le signal d'alarme étant produit par combinaison des signaux d'alerte issus des comparateurs.

Le circuit de protection constitue ainsi un commutateur de puissance avec des éléments parasites faibles, un simple transistor de commutation ne permettant pas à la fois d'effectuer une protection du MOSFET et de permettre son fonctionnement normal hors protection.

Contrairement aux circuits de protection de l'art antérieur, les moyens de commutation sont basés sur la diode et non sur le transistor de commutation. Le transistor de commutation est utilisé pour mettre la diode en conduction la mettre en mode bloqué. Selon un mode de réalisation, le transistor de commutation est un transistor à effet de champ.

Le circuit selon l'invention peut comporter une résistance de contre-polarisation, ladite résistance étant alimentée sur sa première borne par une source de tension et reliée par sa deuxième borne au drain du transistor de commutation.

Selon un autre mode de réalisation, la diode est une diode Schottky.

Selon un mode de réalisation dans lequel le MOSFET est à enrichissement, le conducteur électrique est relié à la masse électrique.

Le signal d'alarme peut être généré par un module de commande comportant au moins un comparateur, lequel compare un signal de référence avec un second signal représentant une grandeur physique à surveiller pour générer un signal d'alerte lorsque le second signal dépasse un seuil défini par le signal de référence, le signal d'alarme étant produit par combinaison des signaux d'alerte issus des comparateurs.

Selon un mode de réalisation, le MOSFET est un MOSFET de puissance.

D'autres caractéristiques apparaîtront à la lecture de la description détaillée donnée à titre d'exemple et non limitative qui suit faite en regard de dessins annexés qui représentent :
- la figure 1, un premier mode de réalisation d'un circuit comportant un module protecteur selon l'invention,
- la figure 2, un schéma équivalent montrant le principe du module protecteur selon l'invention,
- la figure 3, un second mode de réalisation d'un circuit comportant un module protecteur selon l'invention,
- la figure 4, un mode de réalisation d'un module de commande produisant un signal d'alarme pour le module protecteur selon l'invention,
- la figure 5, une mise en oeuvre du module protecteur selon l'invention sur des MOSFET en montage symétrique.

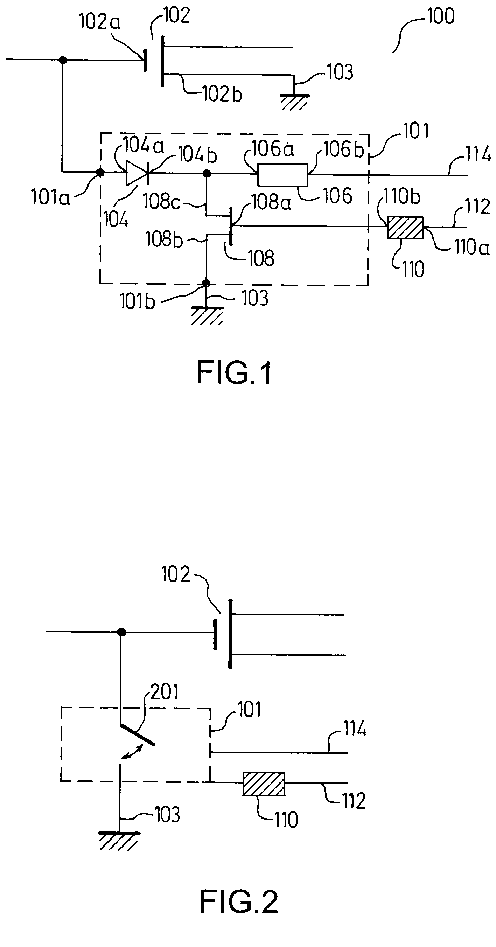

La figure 1 présente un mode de réalisation d'un circuit comportant un module protecteur selon l'invention. Un MOSFET 102 compris dans un dispositif électronique 100, par exemple un circuit d'amplification de puissance, est associé à un module protecteur 101.

Une première borne d'accès 101a au module protecteur 101 est reliée à la grille 102a du MOSFET 102 à protéger. Une seconde borne d'accès 101b au module protecteur 101 est reliée à la masse électrique 103. Une troisième borne d'accès 101c au module protecteur 101 est reliée à un module de commande 110. La source 102b du MOSFET 102 est reliée à la masse électrique 103. Dans l'exemple de la figure 1, le module protecteur 101 comporte une diode 104, une résistance 106, et un transistor 108. Le transistor 108 est, dans l'exemple, un transistor à effet de champ, ce type de transistor étant approprié pour effectuer des commutations. L'anode 104a de la diode 104 est connectée à la première borne d'accès 101a au module protecteur 101. La cathode 104b de la diode 104 est reliée à une première borne 106a de la résistance 106 et au drain 108c du transistor 108. La source 108b du transistor 108 est reliée à la seconde borne d'accès 101b au module protecteur 101, c'est à dire à la masse électrique 103, tandis que la grille 108a du transistor 108 est reliée à la troisième borne d'accès 101c au module protecteur 101, autrement dit, au module de commande 110. La seconde borne 106b de la résistance 106 est reliée à une source de tension 114.

Le module de commande 110 reçoit en entrée 110a des signaux indicateurs 112 issus, par exemple, de capteurs disposés dans le dispositif électronique 100. Ces capteurs permettent, par exemple, de surveiller la température, le taux d'ondes stationnaires présent dans le circuit ou encore le courant reçu au niveau de la grille du MOSFET 102. Un capteur indiquant une valeur anormale permet d'anticiper des conditions de fonctionnement hostiles pour le MOSFET 102, une valeur anormale déclenchant un signal d'alarme et/ou un signal de commande afin de prévenir l'endommagement du MOSFET 102. Par exemple, un changement brutal de charge en sortie du dispositif électronique 100 accroît soudainement le taux d'ondes stationnaires présent dans le dispositif 100. Aussi, un seuil, mémorisé par exemple au niveau du module de commande 110, est déterminé en fonction du taux minimal d'ondes stationnaires à partir duquel la protection du MOSFET 102 doit être déclenchée, ce seuil étant notamment choisi selon les caractéristiques du MOSFET 102 utilisé. Si le taux d'ondes stationnaires dépasse le seuil choisi, alors un signal d'alarme 111 est délivré sur une sortie 110b du module de commande 110. D'autres seuils, correspondant chacun à une grandeur physique à surveiller, peuvent être mémorisés dans le module de commande 110.

Dans l'exemple de la figure 1, le MOSFET 102 à protéger est à enrichissement, ce qui signifie qu'un potentiel électrique nul au niveau de la grille 102a du MOSFET 102 suffit à le bloquer.

Par ailleurs, la grille 108a du transistor 108 est commandée par un signal issu de la sortie 110b du module de commande 110. Ce signal est un courant électrique reçu par la grille du transistor 108a, augmentant alors la tension V_{GS} entre la grille 108a et la source 108b du transistor 108. L'augmentation de la tension V_{GS} agit comme une commande permettant, lorsque V_{GS} dépasse la tension de seuil du transistor 108, de quasiment court-circuiter le drain 108c du transistor 108 avec sa source 108b, laquelle est connectée à la masse électrique 103. Ainsi, lorsqu'un courant est produit en sortie 110b du module de commande 110, un court-circuit est sensiblement opéré entre la première borne d'accès 101a et la deuxième borne d'accès 101b du module protecteur 101, c'est à dire, dans l'exemple, entre la grille 102a du MOSFET 102 et la masse électrique 103. Cette conduction permet de dériver le courant de grille 102a du MOSFET 102 vers la masse électrique 103, stoppant ainsi l'excitation du MOSFET 102. Le MOSFET 102 reste alors bloqué, donc protégé.

Selon une variante du module protecteur selon l'invention, la deuxième borne d'accès 101b du module protecteur 101 est reliée à une source de tension et non pas à la masse électrique 103 comme illustré en figure 1. Cette variante peut notamment être employée pour protéger des MOSFET à appauvrissement pour lesquels une polarisation de la grille 102a du MOSFET 102 à une tension non nulle est nécessaire pour pouvoir bloquer le MOSFET 102. A titre d'exemple, dans le cas d'un MOSFET 102 à canal N à appauvrissement, la deuxième borne d'accès 101b du module protecteur 101 est reliée à une source de tension négative, de manière à polariser la grille 102a du MOSFET 102 pour annuler la conductivité du canal de conduction.

Comme l'illustre la figure 2, le module protecteur 101 peut être modélisé comme un interrupteur 201 entre la grille 102a du MOSFET 102 et un potentiel électrique qui, dans l'exemple, est la masse électrique 103. En effet, le transistor 108 joue un rôle d'interrupteur commandé par le module de commande 110. Sans anomalie détectée par le module de commande 110, l'interrupteur formé par le transistor 108 et la diode 104 (fig.1) reste ouvert, ce qui rend le module protecteur 101 quasi-transparent électriquement vis à vis du MOSFET 102. Lorsqu'un signal d'alarme 111 est produit par le module 110, la tension V_{GS} augmente soudainement et le transistor 108 conduit le courant entre son drain 108c et sa source 108b, autrement dit, l'interrupteur 201 est placé en position fermée.

La diode 104 masque la capacité parasite du transistor 108 lorsque celui-ci est en mode ouvert, c'est-à-dire lorsqu'il ne conduit pas le courant entre son drain 108c et sa source 108b. Sans la diode 104, la capacité parasite du transistor 108 se placerait en parallèle au MOSFET 102 limiterait fortement le fonctionnement aux fréquences élevées du circuit. Grâce à la présence de la diode 104, pourvue d'une faible capacité inverse équivalente, on peut annuler les effets de la capacité parasite du transistor 108 lorsqu'il est placé en position ouverte. A titre d'illustration, pour une capacité C1 parasite du transistor 108 égale à 100pF, une capacité C2 équivalente de la diode 104 égale à 2pF, la capacité CS résultante due au transistor 108 et à la diode 104 est égale à 1/(1/C1+1/C2) ≈ 1.96pF. Autrement dit, lorsque la capacité parasite C1 du transistor 108 est très grande devant la capacité C2 équivalente de la diode 104, la capacité CS résultant de l'association en série de ces deux capacités est quasiment égale à celle de la diode 104, donc à une capacité CS très faible. L'influence néfaste de cette capacité résultante CS est donc largement amoindrie grâce à la présence de la diode 104.

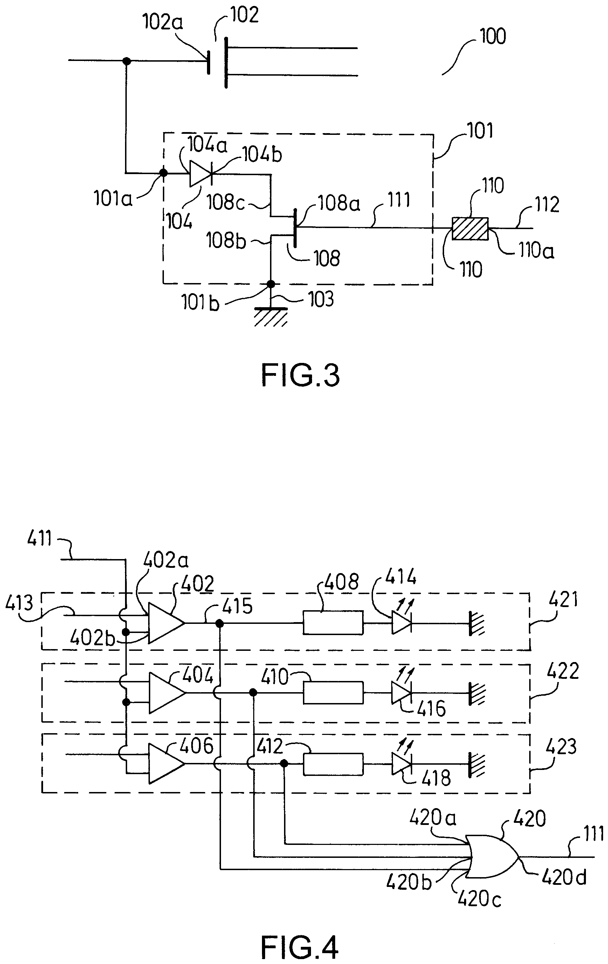

Afin de maintenir une tension V_{DS} positive entre le drain 108c et la source 108b du transistor 108 lorsque le courant d'excitation de la grille 102a du MOSFET 102 est alternatif, la diode 104 effectue un redressement à demi-alternance du courant. Aux fréquences élevées, celles de l'ordre par exemple de 1 GHz, une diode PIN (acronyme anglo-saxon pour « Positive Intrinsic Negative Diode ») est, de préférence, employée pour ses faibles temps de commutation. Dans ce cas, la résistance 106 de contre-polarisation alimentée par la source de tension 114 devient nécessaire. A des fréquences moins élevées, par exemple de l'ordre de quelques centaines de kilohertz, une diode de type Schottky peut être utilisée, auquel cas la résistance 106 de contre-polarisation n'est pas nécessaire, comme l'illustre la figure 3 qui présente un second mode de réalisation du module protecteur selon l'invention dans lequel aucune résistance de polarisation n'est utilisée. Les éléments identiques aux éléments déjà présentés sur les autres figures portent les mêmes références.

Selon un autre mode de réalisation, l'interrupteur 201 entre la grille 102a du MOSFET 102 et la masse électrique 103 peut être réalisé avec d'autres moyens, par exemple par thyristor ou par microsystème électromécanique, souvent qualifié de MEMS en référence à l'acronyme anglo-saxon « Micro Electro Mechanical Systems ».

Afin de mieux comprendre le principe d'activation du module protecteur 101, la figure 4 présente un mode de réalisation d'un module de commande utilisé pour le module protecteur selon l'invention. Le module de commande 110 de la figure 4 comporte, pour chaque grandeur physique surveillée, un comparateur de tension à seuil 402, 404, 406, une bascule 408, 410, 412, et une diode électroluminescente 414, 416, 418. Dans l'exemple de la figure 4, trois grandeurs physiques sont surveillées : la température, le taux d'ondes stationnaires, et le courant d'excitation reçu par la grille 102a du MOSFET 102. D'autres grandeurs physiques pourraient être surveillées par le dispositif. Une première partie 421 du module de commande 110, permettant de surveiller la température est décrite de manière plus détaillée ci-après. Chacune des autres parties 422, 423 du module de commande 110 permet de surveiller une autre grandeur physique et est réalisée selon le même principe que la première partie 421.

La première partie 421 comporte un comparateur 402 comprenant deux entrées 402a, 402b. Un premier signal électrique 413 dont les caractéristiques dépendent de la température est dirigé vers la première entrée 402a, tandis que la seconde entrée 402b reçoit un signal électrique 411 de référence. A titre d'exemple, l'amplitude du premier signal 413 indique la température mesurée au niveau du dispositif électronique 100 et le signal 411 de référence est un courant continu de 5V. Le premier signal 413 représentant la température peut être généré par le dispositif électronique 100 à l'aide de capteurs connus de l'homme du métier, de même que les autres signaux représentant les autres grandeurs physiques surveillées. Le comparateur 402 comprend également une sortie 402c qui fournit le résultat de la comparaison entre le premier signal 413 et le signal électrique 411 de référence. Dans l'exemple, la tension du signal 411 de référence est choisie en fonction de la valeur maximale de température admise par le dispositif électronique 100. Un premier signal 413 de tension supérieure à celle du signal 411 de référence conduit à produire un signal d'alerte 415 en sortie 402c du comparateur. Lorsque la tension du premier signal 413 ne dépasse pas la tension du signal 411 de référence, aucun signal n'est émis en sortie du comparateur 402 de l'exemple. Pour les autres parties 421, 422, 423 du module de commande 110, une même valeur de tension ou des valeurs de tension de référence différentes peuvent être utilisées. La sortie 402c du comparateur 402 est reliée à une bascule 408 montée en série avec une diode électroluminescente 414. En l'absence de signal d'alerte 415 au niveau de la sortie 402c du comparateur 402, la bascule 408 demeure en position ouverte. Dès qu'un signal d'alerte 415 est reçu par la bascule 408, celle-ci est placée en position fermée, de manière à allumer la diode électroluminescente 414. Cette diode électroluminescente 414 permet d'alerter l'utilisateur du dispositif électronique 100 qu'une température anormale a été atteinte. Selon un mode de réalisation simplifié, le module de commande 110 ne comporte ni bascule, ni diode électroluminescente. Chaque partie 421, 422, 423 est donc susceptible de fournir un signal d'alerte au niveau de la sortie 402c, 404c, 406c du comparateur 402, 404, 406. Pour produire le signal d'alarme 111 permettant d'activer le module protecteur 101 (figure 1), ces signaux d'alerte sont rassemblés dans une fonction logique, qui dans l'exemple, est un module de « ou inclusif » 420. Ainsi la sortie 402c, 404c, 406c de chaque comparateur 402, 404, 406 est reliée à une entrée 420a, 420b, 420c du module de « ou inclusif » 420, de sorte que, si au moins un des comparateurs 402, 404, 406 produit un signal d'alerte, le module de « ou inclusif » génère un signal d'alarme 111 sur sa sortie 420d, reliée à la sortie 110b du module de commande 110. En conséquence, si au moins une des grandeurs physiques surveillées évolue anormalement, ce qui est le signe d'un dysfonctionnement du dispositif 100, alors un signal d'alarme 111 est généré en sortie 110b du module de commande 110.

Un même module de commande 110 peut être associé à plusieurs circuits protecteurs 101 de manière à commander plusieurs blocages de grilles de MOSFET concomitamment.

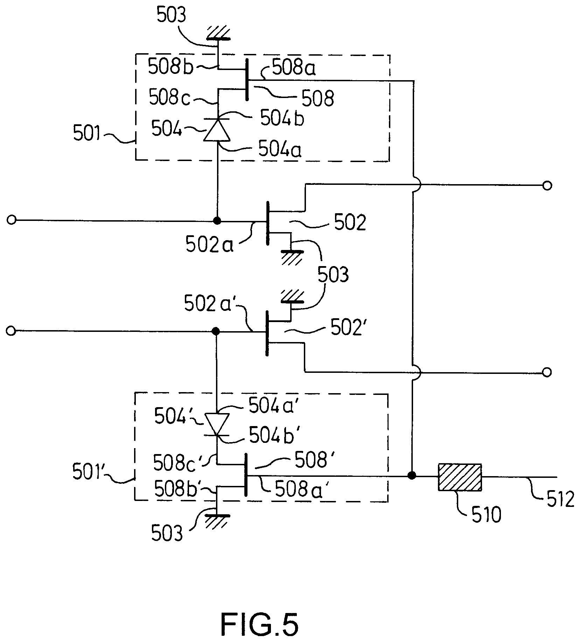

Pour illustrer ce principe, la figure 5 présente une mise en oeuvre du module protecteur selon l'invention sur des MOSFET en montage symétrique. La grille 502a d'un premier MOSFET 502 est reliée à un premier module protecteur 501 et la grille 502a' d'un second MOSFET 502' est reliée à un second module protecteur 501'. Dans l'exemple, chaque module protecteur 501, 501' comporte, comme dans le mode de réalisation présenté en figure 3, un transistor 508, 508' et une diode 504, 504' dont l'anode 504a, 504a' est reliée à l'entrée 501a, 501a' du module protecteur 501, 501' et dont la cathode 504b, 504b' est reliée au drain 508c, 508c' du transistor. La source 508b, 508b' du transistor est reliée à la masse électrique 503. Un module de commande 510 recevant des signaux indicateurs 512 est relié à la grille 508a, 508a' de chacun des transistors 508, 508'.

Un avantage du module protecteur selon l'invention est qu'il ne requiert que quelques composants simples, ce qui en fait un circuit peu encombrant et peu coûteux.

## Revendications

1. Circuit comportant au moins un MOSFET (102) protégé par un module de blocage (101) dudit MOSFET, le module (101) étant placé entre la grille (102a) du MOSFET et un conducteur électrique (103), le module comportant des moyens de connexion commutés (201) ayant au moins deux états :
▪ un premier état opérant une connexion de la grille (102a) du MOSFET avec le conducteur (103), lequel est maintenu à un potentiel électrique adapté à bloquer le MOSFET (102), ce premier état étant activé en présence d'un signal d'alarme (111),
▪ un deuxième état opérant une déconnexion de la grille (102a) du MOSFET, ce deuxième état étant activé en l'absence de signal d'alarme (111),
les moyens de commutation (201) comportent au moins une diode PIN (104) et un transistor de commutation (108) à effet de champ, l'anode (104a) de la diode étant reliée à la grille (102a) du MOSFET, la cathode (104b) de la diode étant reliée au drain (108c) du transistor de commutation, la source (108b) du transistor de commutation étant reliée au conducteur électrique (103), et la grille (108a) du transistor de commutation étant commandée par le signal d'alarme (111), le MOSFET opérant en radiofréquences,
où le signal d'alarme (111) est généré par un module de commande (110) comportant une pluralité de comparateurs (402, 404, 406), dont au moins un comparateur compare un signal de référence (411) avec un second signal (413) représentant une grandeur physique à surveiller pour générer un signal d'alerte (415) lorsque le second signal (413) dépasse un seuil défini par le signal de référence (411), le signal d'alarme (111) étant produit par combinaison des signaux d'alerte issus des comparateurs.

2. Circuit selon la revendication 1, **caractérisé en ce qu'**il comporte une résistance (106) de contre-polarisation, ladite résistance étant alimentée sur sa première borne (106b) par une source de tension et reliée par sa deuxième borne (106a) au drain du transistor de commutation.

3. Circuit selon l'une des revendications précédentes, le MOSFET (102) étant à enrichissement, **caractérisé en ce que** le conducteur électrique (103) est relié à la masse électrique.

4. Circuit selon l'une des revendications précédentes, **caractérisé en ce que** le MOSFET (102) est un MOSFET de puissance.

## Patentansprüche

1. Schaltung, beinhaltend mindestens einen MOSFET (102), welcher durch ein Blockiermodul (101) des MOSFET geschützt wird, wobei das Modul (101) zwischen dem Gitter (102a) des MOSFET und einem elektrischen Leiter (103) platziert ist, wobei das Modul umgeschaltete Kopplungsmittel (201) besitzt, welche mindestens zwei Zustände aufweisen:
▪ einen ersten Zustand, welcher eine Kopplung des Gitters (102a) des MOSFET an den Leiter (103) herbeiführt, welcher bei einem elektrischen Potenzial gehalten wird, welches geeignet ist, den MOSFET (102) zu blockieren, wobei der erste Zustand bei Vorliegen eines Alarmsignals (111) aktiviert wird,
▪ einen zweiten Zustand, welcher die Entkopplung des Gitters (102a) des MOSFET herbeiführt, wobei der zweite Zustand bei Nichtvorliegen eines Alarmsignals (111) aktiviert wird,
wobei die Umschaltmittel (201) mindestens eine PIN-Diode (104) und einen Umschalttransistor (108) mit Feldeffekt beinhalten, wobei die Anode (104a) der Diode mit dem Gitter (102a) des MOSFET verbunden ist, die Kathode (104b) der Diode mit dem Drain (108c) des Umschalttransistors verbunden ist, die Quelle (108b) des Umschalttransistors mit dem elektrischen Leiter (103) verbunden ist und das Gitter (108a) des Umschalttransistors durch das Alarmsignal (111) angesteuert wird, wobei der MOSFET mit Hochfrequenzen arbeitet,
wobei das Alarmsignal (111) durch ein Steuermodul (110) erzeugt wird, welches eine Vielzahl von Komparatoren (402, 404, 406) beinhaltet, von welchen mindestens ein Komparator ein Referenzsignal (411) mit einem zweiten Signal (413) vergleicht, welches eine zu überwachende physikalische Größe darstellt, um ein Alarmsignal (415) zu erzeugen, wenn das zweite Signal (413) einen durch das Referenzsignal (411) definierten Grenzwert überschreitet, wobei das Alarmsignal (111) durch Kombination der Alarmsignale erzeugt wird, welche aus den Komparatoren stammen.

2. Schaltung nach Anspruch 1, **dadurch gekennzeichnet, dass** sie einen Gegenpolarisations-Widerstand (106) beinhaltet, wobei der Widerstand an seiner ersten Klemme (106b) durch eine Spannungsquelle versorgt wird und über seine zweite Klemme (106a) mit dem Drain des Umschalttransistors verbunden ist.

3. Schaltung nach einem der vorhergehenden Ansprüche, wobei der MOSFET (102) ein Anreicherungs-MOSFET ist, **dadurch gekennzeichnet, dass** der elektrische Leiter (103) mit der elektrischen Masse verbunden ist.

4. Schaltung nach einem der vorhergehenden Ansprüche, **dadurch gekennzeichnet, dass** der MOSFET (102) ein Leistungs-MOSFET ist.

## Claims

1. A circuit comprising at least one MOSFET (102) protected by a module for blocking (101) said MOSFET, the module (101) being placed between the gate (102a) of the MOSFET and an electrical conductor (103), the module comprising switched connection means (201) having at least two states:
▪ a first state which connects the gate (102a) of the MOSFET to the conductor (103), which is maintained at an electrical potential suitable for blocking the MOSFET (102), this first state being activated in the presence of an alarm signal (111),
▪ a second state which disconnects the gate (102a) of the MOSFET, this second state being activated in the absence of the alarm signal (111),
wherein the switching means (201) comprise at least one diode PIN (104) and a field-effect switching transistor (108), the anode (104a) of the diode being connected to the gate (102a) of the MOSFET, the cathode (104b) of the diode being connected to the drain (108c) of the switching transistor, the source (108b) of the switching transistor being connected to the electrical conductor (103), and the gate (108a) of the switching transistor being controlled by the alarm signal (111), the MOSFET operating at radiofrequencies,
wherein the alarm signal (111) is generated by a control module (110) comprising a plurality of comparators (402, 404, 406), among which at least one comparator compares a reference signal (411) with a second signal (413) representing a physical quantity to be monitored in order to generate an alert signal (415) when the second signal (413) exceeds a threshold defined by the reference signal (411), the alarm signal (111) being produced by combining the alert signals obtained from the comparators.

2. The circuit as claimed in claim 1, **characterized in that** it comprises a reverse-bias resistor (106), said resistor being powered on its first terminal (106b) by a voltage source and connected by its second terminal (106a) to the drain of the switching transistor.

3. The circuit as claimed in any one of the preceding claims, the MOSFET (102) being enriched, **characterized in that** the electrical conductor (103) is connected to the electrical ground.

4. The circuit as claimed in any one of the preceding claims 1, **characterized in that** the MOSFET (102) is a power MOSFET.
